# EUROPEAN PATENT APPLICATION

(11) **EP 1 916 775 A1**
(43) Date of publication of application: **30.04.2008**
(21) Application number: 07445006.5
(22) Date of filing: 28.02.2007
(51) Int. Cl.: H04B 1/18, H03F 3/16

(54) **Antenna device and portable radio communication device comprising such antenna device**

(30) Priority: 27.10.2006 EP 06445069
(71) Applicant: Laird Technologies AB, 184 25 Åkersberga (SE)
(72) Inventor: Kaikkonen, Andrei, 164 71 Kista (SE); Lindberg, Peter, 752 29 Uppsala (SE)
(74) Representative: Estreen, Lars J.F.

(57) **Abstract**

An antenna device for a portable radio communication device comprises a radiating element (10), a filter stage (20) connected to the radiating element, and an amplifier stage (30) connected to the filter stage and connectable to a receiver device for radio signals (40). By providing an amplifier stage that is not unconditionally stable, an antenna device having advantageous characteristics is achieved.

## Description

### FIELD OF INVENTION

The present invention relates generally to antenna devices and more particularly to an antenna device for use in a radio communication device, such as a mobile phone, which is adapted for radio signals having a relatively low frequency, such as radio signals in the FM band.

### BACKGROUND

Internal antennas have been used for some time in portable radio communication devices. There are a number of advantages connected with using internal antennas, of which can be mentioned that they are small and light, making them suitable for applications wherein size and weight are of importance, such as in mobile phones.

However, the application of internal antennas in a mobile phone puts some constraints on the configuration of the antenna element. In particular, in a portable radio communication device the space for an internal antenna arrangement is limited. These constraints may make it difficult to find a configuration of the antenna that provides for a wide operating band. This is especially true for antennas intended for use with radio signals of relatively low frequencies as the desired physical length of such antennas are large compared to antennas operating with relatively high frequencies.

One specific application operating in a relatively low frequency band is the FM radio application. The FM band is defined as frequencies between 88-108 MHz in Europe or between 76-110 MHz in the USA. Prior art conventional antenna configurations, such as loop antennas or monopole antennas, fitted within the casing of a portable radio communication device will result in unsatisfactory operation in that the antenna either has too bad performance over a sufficiently wide frequency band or sufficient performance over a too narrow frequency band.

Instead, a conventional FM antenna for portable radio communication devices is provided in the headset wire connected to the communication device. This configuration with a relatively long wire permits an antenna length that is sufficient also for low frequency applications. However, if no external antenna is permitted this solution is obviously not feasible.

In so-called active antenna devices, some kind of semiconductor, such as a transistor, is used in an amplifier step to amplify the received or transmitted signal, as the case may be. However, in order to ensure that it is stable at all frequencies, the amplifier is resistively loaded on the antenna side. This loading in turn introduces unwanted thermal noise, degrading the noise factor of the amplifier.

### SUMMARY OF THE INVENTION

An object of the present invention is to provide an antenna device for use in a portable radio communication device, which operates with sufficient performance throughout a frequency band having a relatively low frequency, such as the FM radio band.

The invention is based on the realization that a not unconditionally stable amplifier stage can be used while taking into consideration the antenna radiator characteristics, such as impedance, in combination with lack of resistive loading, to provide an antenna device having advantageous characteristics.

According to the present invention there is provided an antenna device for a portable radio communication device adapted for receiving radio signals in at least a first operating frequency band, said antenna device comprising a radiating element, a filter stage connected to the radiating element, and an amplifier stage connected to the filter stage and connectable to a receiver device for radio signals, the antenna device being characterized in that the amplifier stage is not unconditionally stable.

A portable radio communication device comprising such an antenna device is also provided.

The antenna device according to the invention provides stable operation while giving high gain amplification, resulting in a relatively strong low noise RF signal reaching the receiver device for radio signals.

In a preferred embodiment, the amplifier stage lacks resistive loading on the radiating element side, enhancing the performance of the amplifier stage.

In a preferred embodiment, a so-called cascode configuration is used. With this configuration, high isolation between input and output of the amplifier stage with high gain is achieved, ensuring stable amplifier operation. Furthermore, the small input capacitance provides a broadband solution.

Further preferred embodiments are defined in the dependent claims.

### BRIEF DESCRIPTION OF DRAWINGS

The invention is now described, by way of example, with reference to the accompanying drawings, in which:
FIG. 1 is a schematic diagram showing an antenna device according to the invention connected to an FM receiver circuit;
FIG. 2 is a diagram showing in more detail a first embodiment of an antenna device according to the invention;
FIG. 3 is a diagram showing a second embodiment of an antenna device according to the invention; and
FIG. 4 is a perspective partially cut-away view of an antenna device according to the invention mounted in a portable radio communication device.

### DETAILED DESCRIPTION OF THE INVENTION

In the following, a detailed description of preferred embodiments of an antenna device and a portable radio communication device according to the invention will be given.

In the following description and claims, the term radiating element is used. It is to be understood that this term is intended to cover electrically conductive elements arranged for receiving radio signals.

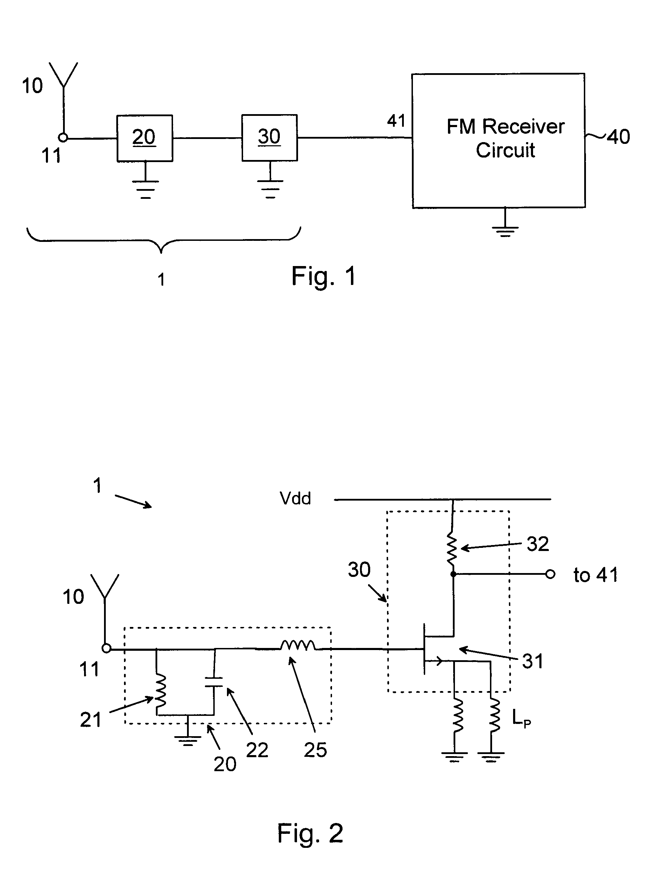

First with reference to FIG. 1, the general configuration of an antenna device 1 according to the invention is shown. It comprises a radiating element 10 in the form of a non-resonant piece of electrically conductive material, such as sheet metal or flex film. An example of the size thereof is 30 times 10 millimeters, placed on the back cover of a portable radio communication device. The radiating element has a feeding portion 11 connected to a filter stage 20 arranged to block signals having a frequency above the operating frequency band and to allow signals in the operating frequency band, i.e., a band pass filter block. It is preferred that the filter stage acts as a band pass filter for signals in the operating frequency band. In the case of operation in the FM band, the pass band is between 88-108 MHz in Europe or between 76-110 MHz in the USA.

One function of the filter stage 20 is to act as ESD protection circuit, effectively blocking the major part of ESD pulse spectrum. The filter also eliminates or at least reduces interference from electro magnetic interference (EMI) signals and possibly signals from other antennas provided in the same radio communication device, such as cellular GSM antennas operating at frequencies well above the FM antenna.

An amplifier stage 30 is arranged after the filter stage 20 for amplifying signals received by the radiating element 10.

Signals received and amplified by the antenna device 1 are supplied to an FM receiver circuit 40, which could be a conventional circuit manufactured by Philips Semiconductors and sold under the name HVQFN40. The FM receiver circuit comprises an RF input 41, which is connected to the amplifier 30.

It is preferred that the filter and amplifier stages are provided relatively close to the radiating element 10 in order to minimize parasitic effects and interference from external sources.

An implementation of the general idea expressed in FIG. 1 will now be described with reference to FIG. 2. The first filter stage 20 is here implemented as a grounded LC circuit comprising an inductor 21 and a capacitor 22 connected in parallel and between the feeding portion 11 and ground. In one embodiment, the inductance of inductor 21 is approximately 40 nH and the capacitance of capacitor 22 is approximately 60 pF.

The inductor 21 and the capacitor 22 together form a band pass filter for the FM band. A low pass filter 25 in the form of a series inductor 26 connected in the RF signal path is provided after the band pass filter. A preferred inductance value of inductor 26 is in the range of 50-200 mH, and more preferably in the order of 100 mH.

The amplifier stage 30 comprises a field effect transistor (FET) 31 with the gate connected to the filter 20, the source connected directly to ground and the drain connectable to the input 41 of the FM receiver circuit 40. There is also a load resistor 32 connected between the drain of the transistor 31 and the feed voltage Vdd.

It should be noted that there are no loading resistors conventionally found in amplifier stages to increase the stability of the device, such as a resistor interconnected between the gate of the FET and a bias voltage or a feedback resistor connected between the drain and the gate of the FET. Partly since the resistive loading is lacking, the amplifier stage in itself is not stable at all frequencies. However, by co-designing the radiating element and the amplifier stage, the combination thereof, i.e., the antenna device can be designed so as to be stable at all frequencies.

In order for the antenna device 1 to operate, the transistor preferably has a minimum noise figure below 1 dB and a gain above 15 dB in the operating frequency band. Also, it is preferred that the transistor has a noise resistance Rn of less than 10 Ohms in order to achieve highest possible signal reception quality for arbitrary antenna configurations.

By co-designing the amplifier stage 30 and the radiating element 10 so that the radiating element shows a different conjugate reactance than the amplifier stage when the transistor shows a negative resistance on the input thereof, the risk of self-oscillation in the antenna device is eliminated or at least minimized.

In order to minimize the feedback and thereby the negative resistance for any relevant frequency, the parasitic inductance, designated Lₚ, between the source of the FET 31 and ground should be minimized. This could be achieved in several ways, of which one is shown in the figures. By providing a plurality of contact pins between the FET source and ground, preferably three or more, the inductance value is reduced, in turn reducing the risk for self-resonance, i.e., instability.

The ground plane to which the source of the FET 31 is connected is conventionally provided on the opposite side of the printed circuit board (PCB) on which the transistor component is mounted. One way to reduce the parasitic inductance is therefore to provide the FET 31 on a PCB, which is as thin as possible, and preferably 0.5 mm or thinner.

With a thicker PCB there is the possibility to provide the ground plane to which the source of the FET 31 is connected on the same side as the transistor component itself.

Yet another way to reduce parasitic inductance is to provide the transistor component with as short pins as possible.

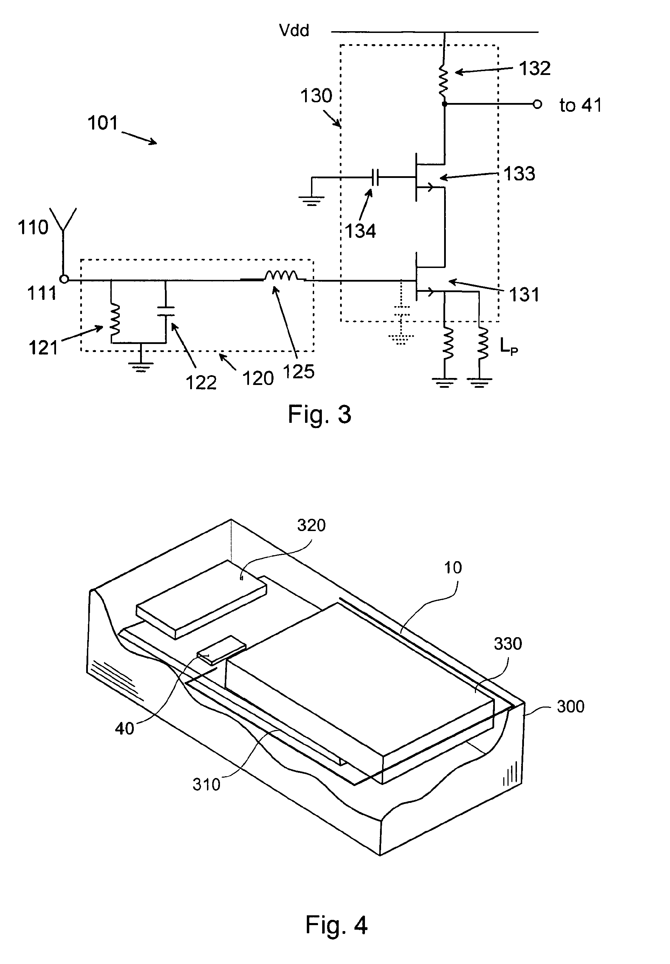

An alternative implementation of the inventive idea in the form of a second embodiment will now be described with reference to FIG. 3. Like the above described first embodiment, this antenna device comprises a radiating element 110 having a feed portion 111 connected to a filter stage 120 with components corresponding to those of the first embodiment. However, in this second embodiment the amplifier stage is a so-called cascode amplifier 130. This cascode amplifier comprises a field effect transistor 131 with the gate connected to the filter 120, the source connected directly to ground and the drain connected to the source of a second field effect transistor 133. The gate of the second transistor 133 is connected to ground via a capacitor 134. The drain of the second transistor 133 is connectable to the input 41 of the FM receiver circuit 40. There is also a load resistor 132 connected between the drain of the second transistor 133 and the feed voltage Vdd.

A preferred position of the antenna device according to the invention as described above with reference to FIGs. 1-3 will now be described with reference to FIG. 4, wherein the general outlines of the casing of a portable radio communication device 300, such as a mobile phone, is depicted. The casing is shown partially cut away so as to not obscure the position of the antenna device, which could be any of the devices described with reference to FIGS 1-3.

A printed circuit board (PCB) 310 is provided in the casing, having the circuits (not shown) conventionally found in a mobile phone. On the PCB there is also mounted the FM receiver circuit 40. In the upper portion of the casing there is provided an antenna radiating element 320 for receiving and transmitting RF signals for a cellular mobile phone system, such as a GSM system.

A battery package 330 is also provided towards the back of the casing 300. This battery package is connected to the PCB by means of connectors (not shown). FM antenna radiator is preferably placed on the back cover. The radiator can comprise a thin stripe going around the battery. When the back cover is made of metal, it can directly be utilized as the FM antenna radiator element. Alternatively, a headset cable can be used as the FM antenna radiator element.

Preferred embodiments of an antenna device according to the invention have been described. However, the person skilled in the art realizes that these can be varied within the scope of the appended claims without departing from the inventive idea.

It is realized that the shape and size of the antenna device according to the invention can be varied within the scope defined by the appended claims. Thus, the exact antenna configurations can be varied so as to correspond to the shape of the radio communication device, desired performance etc.

The above-described embodiments of an antenna device according to the invention have been described as antenna devices adapted for reception of radio signals in the FM frequency band. However, other applications are also possible, such as use for digital video broadcasting (DVB) signals in the frequency range of about 400-800 MHz.

Although an antenna device for a portable radio communication device has been described with reference to its use in a mobile phone, it will be appreciated that the inventive idea is also applicable to other portable radio communication devices, also devices that are portable but primarily intended for stationary use. Examples thereof could be small clocks, such as travel alarm clocks, TV receivers, or game consoles. Yet a possible application of the antenna device according to the invention is in personal digital assistants (PDAs), MP3 and CD players, FM radio receivers, and laptop computers. A further application is in cars. Thus, the term portable radio communication device should be construed in a broad sense.

A FET has been described as the preferred transistor type. It will be realized that other types of transistors, such as heterojunction bipolar transistors (HBT), can be used as well.

## Claims

1. An antenna device for a portable radio communication device adapted for receiving radio signals in at least a first operating frequency band, said antenna device comprising
- a radiating element (10; 110),
- a filter stage (20; 120) connected to the radiating element, and
- an amplifier stage (30; 130) connected to the filter stage and connectable to a receiver device for radio signals (40),
**characterized in that**
- the amplifier stage is not unconditionally stable.

2. The antenna device according to claim 1, wherein the amplifier stage (30; 130) comprises a transistor (31; 131).

3. The antenna device according to claim 2, wherein a plurality of contact pins are arranged between the transistor and ground.

4. The antenna device according to claim 2 or 3, wherein a ground plane to which the transistor (31; 131) is connected is provided on the opposite side of a printed circuit board (310) on which the transistor component is mounted, and wherein the printed circuit board (310) is 0.5 mm or thinner.

5. The antenna device according to any of claims 2-4, wherein the transistor (31; 131) is connected on the same side of a printed circuit board (310) as the transistor itself.

6. The antenna device according to any of claims 2-5, wherein the transistor is a field effect transistor.

7. The antenna device according to any of claims 2-6, comprising a second transistor (133) provided between the drain of the transistor (131) and the resistor (132), wherein the source of the second transistor is connected to the drain of the transistor, the gate of the second transistor is connected to ground, and the drain of the second transistor is connected to the resistor.

8. The antenna device according to any of claims 1-7, wherein the radiating element (10) is non-resonant.

9. The antenna device according to any of claims 1-8, wherein the amplifier stage (30; 130) lacks resistive loading on the radiating element side,

10. A portable radio communication device comprising an antenna device according to claim 1.
